# EUROPEAN PATENT APPLICATION

(11) **EP 2 463 670 A1**
(43) Date of publication of application: **13.06.2012**
(21) Application number: 10194090.6
(22) Date of filing: 08.12.2010
(51) Int. Cl.: G01R 21/133

(54) **Voltage based load monitoring system**

(71) Applicant: Koninklijke Philips Electronics N.V., 5621 BA Eindhoven (NL)
(72) Inventor: The designation of the inventor has not yet been filed
(74) Representative: Volmer, Georg

(57) **Abstract**

The invention introduces new techniques to detect types of loads connected to an electricity distribution system that feeds premises with a DC voltage. Connected loads are designed to operate on the DC voltage. The new techniques are ripple (created by loads) frequency detection and steady state voltage measurement. These techniques implemented with the help of an electronic system having one voltage sensor and a microcontroller along with display and communication devices.

## Description

### FIELD OF THE INVENTION

The invention relates to a load monitoring apparatus, method and system for providing information about a connected type of load in an electrical distribution system.

### BACKGROUND OF THE INVENTION

Sustainable energy sources are playing a significant role in covering current and future energy demands. Renewable energy sources installed at houses supply their loads while having the capability of autonomously injecting their excess energy to the main grid. This leads to a reduction for the power flowing in connecting lines. Such system will increase the grid security and decrease power losses. However, renewable energy has some disadvantages due to its dependency on nature's conditions. In case of photovoltaics (PV) and wind, it is not predicted the amount of power they can provide at a specific time. At some instants, these sources will not be able to produce the required energy demanded by the load. At another instant, they are capable of providing energy that is more than what is needed for the load. In such situations, it is crucial to inject the maximum power generated by each renewable energy source at any instant of time.

Direct current (DC) distribution systems (also called "DC grids") have been suggested lately as a better method for electrical power delivery. This concept is inspired by the possibility of efficient integration of small distributed generation units which attract the attention of researchers all over the world. Moreover, there are other advantages having electrical power transmitted through DC distribution systems like the relatively higher efficiency, absence of reactive power component and the fact that many appliances operate using a DC voltage. The feasibility of using DC distribution systems instead of alternating current (AC) ones is being investigated by many researchers.

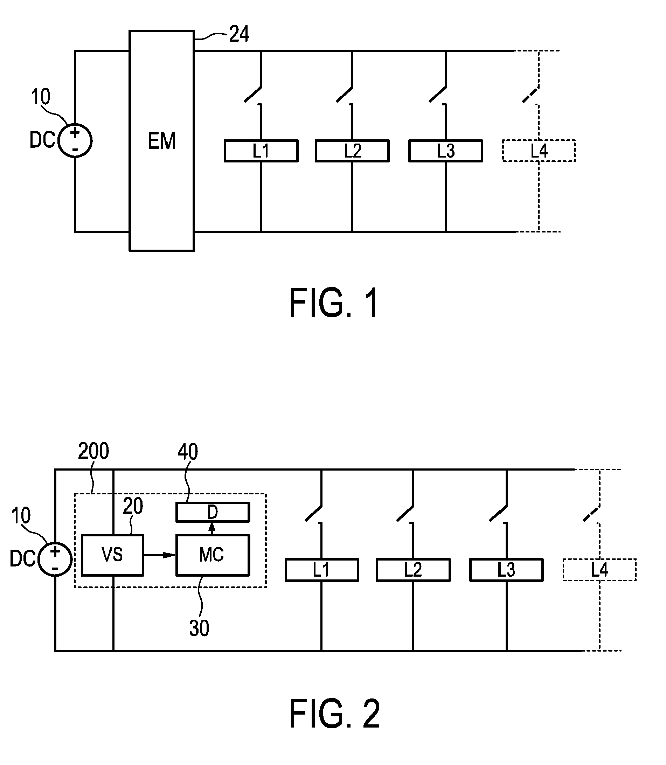

Fig. 1 shows a typical DC electrical distribution system. DC voltage is generated directly from a DC source 10, such as a solar PV based system. DC loads L1 to L4 like light emitting diodes (LED) lighting, DC fan, variable frequency drives (VFDs) etc are connected to a common DC bus. AC loads can also be connected to the system with the help of proper AC to DC conversion. An energy meter (EM) 24 is connected at a central point to measure total energy/power consumed by the premises to which the electrical energy is distributed. This energy meter 24 can only provide measurement of total energy consumed but cannot provide any information about the power/energy consumed by individual loads.

Load detection and measurement techniques exist for AC grids, as for example described in Hart, G.W., "Non-intrusive Appliance Load Monitoring", Proc. of IEEE, vol.80, No 12, Dec 1992, pp. 1870-1891. But, so far techniques have not been tried and tested for DC distribution systems. In AC grids, current or voltage or both are used to detect a type of load connected in the system, such as described for example in S.B. Leeb et al "Transient event detection in spectral envelope estimates for nonintrusive load monitoring," IEEE Trans. Power Delivery, vol. 10, no. 3, , July 1995, pp. 1200-1210 or in Robert Cox et al, "Transient Event Detection for Nonintrusive Load Monitoring and Demand Side Management Using Voltage Distortion," IEEE APEC 2006, Page 7. Voltage based techniques use transient sag and swell in voltage (generated due to switching ON/OFF of loads) to establish type of load got connected/disconnected.

A main disadvantage of a conventional energy meter is that it measures only energy/power but does not provide any information about individual loads. This has been addressed by techniques called non-intrusive load monitoring. Such load monitoring systems use current-based information and therefore require to be implemented as centralized systems.

### SUMMARY OF THE INVENTION

It is an object of the present invention to provide a more flexible load monitoring system for DC distribution systems.

This object is achieved by a load monitoring apparatus as claimed in claim 1, by a load monitoring system as claimed in claim 6, by a method as claimed in claim 10, and by a computer program product as claimed in claim 11.

Accordingly, active connected loads on a DC grid can be deteceted solely by sensing the output voltage voltage, so that a current sensor is no longer required. The proposed detection and evaluation techniques are customized for DC grids to detect the type of loads connected to the system. This provides the advantage that the proposed voltage-based load monitoring system can be plugged in any electrical socket to recognize which load has been turned on or off with minimum regard to its position with respect to the electricity distribution network.

According to a first aspect, the pattern detector or detection functionality may be adapted to detect at least one predetermined ripple frequency of the monitored output voltage. Hence, simple frequency extraction and evaluation can be used for load classification.

According to a second aspect which can be combined with the first aspect, the load classifier or classifying functionality may be adapted to determine a non-linear load if one of the predetermined ripple frequencies has been detected. Thus, load-specific switching frequencies or the like introduced into the DC grid can be used for load classification.

According to a third aspect which can be combined with at least one of the first and second aspects, the pattern detector or detection functionality may be adapted to detect at least one of a transient change and a steady state change of the monitored output voltage, wherein the load classifier or classifying functionality may be adapted to determine the type of load based on at least one of the determined transient change and the determined steady state change of the monitored output voltage. Hence, the type of load can be detected and classified based on its behaviour when switched on or off.

The pattern detector or detection functionality and the load classifier or classifying functionality may be implemented by a micro controller.

According to a fourth aspect which can be combined with at least one of the first to third aspects, the load monitoring system may be configured to detect a type of load of the plurality of loads. Thus, the system can be plugged anywhere into the DC grid to detect types of loads connected thereto.

According to a fifth aspect which can be combined with at least one of the first to fourth aspects, the load monitoring system may be adapted to be attached with a particular one of the plurality of loads and to control the particular one of the plurality of loads based on the provided load information. This provides the advantage that the load monitoring system can be used in a distributed manner to provide intelligence to each load.

In a further aspect of the present invention a computer program for performing noise reduction is provided, wherein the computer program comprises code means for causing the load monitoring apparatus to carry out the steps of the above method, when the computer program is run on a computer controlling the load monitoring apparatus.

It shall be understood that a preferred embodiment of the invention can also be any combination of the dependent claims with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows a schematic circuit diagram of a conventional DC distribution system with energy meter;
Fig. 2 shows a shows a schematic circuit diagram of a DC distribution system with centralized load monitoring according to a first embodiment;
Fig. 3 shows a schematic circuit diagram of a DC distribution system with distributed load monitoring according to a second embodiment; and
Fig. 4 shows a flow diagram of a load monitoring procedure which can be applied in the first and second embodiment.

### DETAILED DESCRIPTION OF EMBODIMENTS

In the following embodiment, load classification techniques customized for DC distribution systems or DC grids are provided so as to enable detection of load types connected to the DC distribution system. These load classification techniques involve at least one of a detection of ripple frequencies present in the supplied voltage of the DC distribution sytsme and steady state changes in the amplitude of the supplied voltage e.g. due to a load change.

The main advantage of the voltage-based load monitoring system proposed in this disclosure is that it can be plugged in any electrical socket to recognize which load has been turned on or off with minimum regard to its position with respect to the electricity distribution network and therefore can be used in a distributed manner to provide intelligence to each load.

Fig. 2 shows a schematic circuit diagram of a DC distribution system with centralized load monitoring system 200 according to a first embodiment which allows detection and classification of active switchably connected loads L1 to L4. To achieve this, the load monitoring system 200 comprises a voltage sensor (VS) 20 connected in parallel to a DC power supply source 10 which generates a DC supply voltage. An analog or digital output of the voltage sensor 20, which corresponds to or reflects the changes of the voltage amplitude is supplied to a micro controller (MC) 30 or any other hardware or software controlled circuit for evaluation and classification purposes, as explained below in moree detail. The result of classification can be displayed on an optional display (D) 40 or any other user interface or output device.

Due to the fact that only the voltage of the DC distribution system is detected, the load monitoring system 200 can be used in a distributed manner to provide intelligence to every load L1 to L2 as explained later in connection with the second embodiment.

In the load monitoring system 200 a set of classification techniques customized for DC distribution systems is used to detect loads and to classify the type of loads connected to the DC distribution system based on predetermined or specific change patterns detected in the monitored time-dependent changes of the amplitude of the DC supply voltage. Thus, the microcontroller 30 provides a pattern detection and load classification functionality as described below. Of course, these functionalities could be implemented as discrete and separate hardware circuits as well. The load monitoring system 200 my thus be implemented as a single chip device, a chip set, a circit board or a software-controlled processor.

The load classification may be based on a detection of ripple frequencies as decisive change pattern. This classification approach is based on the assumption that various types of non-linear loads consume some amount of power at frequencies other than DC. The load current consumed at these frequencies results in a periodic disturbance of the DC supply voltage and this periodic or frequency information can be used to identify type of loads. For example, DC-DC converters connected to the DC distribution system will inject noise at switching frequency which can detected and evaluated to find out its status. This can be used by the load monitoring system 200 to detect and classify the type of load being introduced into the system.

As an alternative or additional classsification option, a steady state change in in the DC supply voltage can be used as decisive change pattern. Namely, as a load is switched ON/OFF, there are two types of changes in the Dc supply voltage. The first one is a transient change due to a high transient current. The second one is a steady-state change in voltage due to increase/decrease of current. In the particular and exemplary case of a solar-PV-based system, this can be attributed to the fact that a charge controller tracks the maximum power point (MPPT) delivered by a solar panel and tunes it to connected loads (e.g. battery bank, utility power, DC motor, or DC pump). When a load is switched on, the MPPT tracker will have to sense the added load and suitable track power output to tune for maximum power output. This is not an instantaneous process and requires some processing. This short duration can introduce voltage transients on the DC distribution system that is dependent on the connected load characteristic. This can be used by the load monitoring system 200 to detect and classify the type of load being introduced into the system.

As the current increases the drop in the line impedance increases and therefore the voltage at the load device's end reduces. Generally in a DC dstribution system power may be generated locally by DC sources like a solar PV. These types of sources have a power electronic converter (DC-to-DC) that produces the required amount of voltage. When a heavy load is connected to the system, the voltage at the load end changes. Conventionally, a voltage sensor at the converter is used through a feedback loop to control the voltage and bring it back to the desired voltage level. Generally, in these kind of systems, a drop control functionality is used which result in change in voltage magnitude with load. The proposed detection and classification technique of the load monitoring system 200 uses this change in voltage to detect a type of load connected to the DC bus through which the DC ssupply voltage is supplied to the loads L1 to L4.

The detection and classification techniques are implemented with the help of the micro controller 30 or any other circuit such as a digital signal processor or a computer or a programmable logic controller (PLC). As shown in Fig. 2, the voltage sensor 20 is used to acquire the amplitude signal or data which is processed to detect loads.

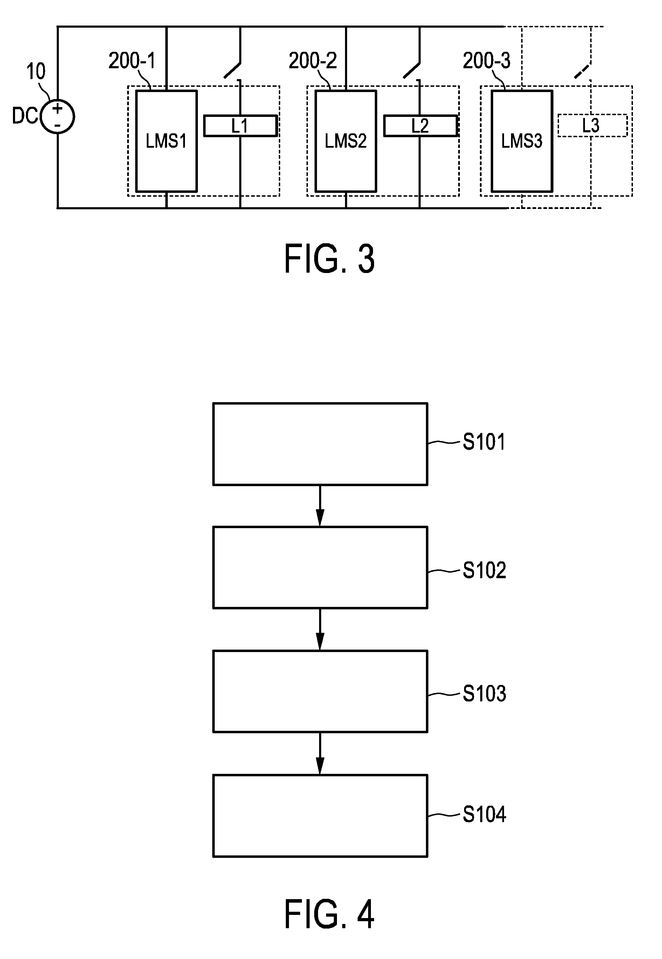

Fig. 3 shows a schematic circuit diagram of a DC distribution system with distributed load monitoring systems 200-1 to 200-3 according to a second embodiment. Here, the voltage based load monitoring systems (LMS1 to LMS3) 200-1 to 200-3 are attached with each load L1 to L3 to provide a distributed load monitoring system. Each of the load monitoring systems 200-1 to 200-3 corresponds to the load monitoring system 200 described in connection with Fig. 2 and may thus be used to control the allocated load so as to provide intelligence to the load. Thus, operation parameters of each of the individual loads L1 to L3 can be controlled based on the detected load type(s) or load type distribution.

Fig. 4 shows a flow diagram of a load monitoring procedure which can be applied in the load monitoring systems 200 and 200-1 to 200-3 of the above first and second embodiments.

In step S101, the output voltage is monitored, e.g. by the voltage sensor 20, and analog-to-digital (A/D) converted for subsequent processing in the digital domain. Then, in step S102, time dependent changes of the monitored output voltage are evaluated with regard to their patterns. In step S103, predetermined change patterns (frequencies, transients or steady state changes) as defined above are detected. Based on the detected change patterns, a decision about the type of load is made in step S104, so that a load type information can be provided.

The above embodiments can be applied in any load monitoring system for applications in homes, offices, hotels and buildings, such as for example in products for lighting and lifestyle.

Other variations to the disclosed embodiments can be understood and effected by those skilled in the art in practicing the claimed invention, from a study of the drawings, the disclosure, and the appended claims.

To summarize, the present invention introduces new techniques to detect types of loads connected to an electricity distribution system that feeds premises with a DC voltage. Connected loads are designed to operate on the DC voltage. The new techniques are ripple (created by loads) frequency detection and steady state voltage measurement. These techniques implemented with the help of an electronic system having one voltage sensor and a microcontroller along with display and communication devices.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

The above steps S101 to S104 of Fig. 4 can be performed by a single unit or by any other number of different units. The calculations, processing and/or control of the load monitoring micro controller 30 can be implemented as program code means of a computer program and/or as dedicated hardware.

The computer program may be stored/distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

The invention introduces new techniques to detect types of loads connected to an electricity distribution system that feeds premises with a DC voltage. Connected loads are designed to operate on the DC voltage. The new techniques are ripple (created by loads) frequency detection and steady state voltage measurement. These techniques implemented with the help of an electronic system having one voltage sensor and a microcontroller along with display and communication devices.

## Claims

1. A load monitoring apparatus for providing a load information in a direct current, DC, distribution system, said apparatus (30) comprising:
- a pattern detector for evaluating time-dependent changes of a monitored DC output voltage received from a voltage sensor (20) and for detecting predetermined change patterns; and
- a load classifier for deciding about a type of load connected to said DC distribution system based on said detected predetermined change pattern.

2. The apparatus according to claim 1, wherein said pattern detector (30) is adapted to detect at least one predetermined ripple frequency of said monitored output voltage.

3. The apparatus according to claim 2, wherein said load classifier (30) is adapted to determine a non-linear load if said pattern detector (30) has detected one of said predetermined ripple frequencies.

4. The apparatus according to claim 1, wherein said pattern detector (30) is adapted to detect at least one of a transient change and a steady state change of said monitored output voltage, and wherein said load classifier (30) is adapted to determine the type of load based on at least one of said determined transient change and said determined steady state change of said monitored output voltage.

5. The apparatus according to claim 1, wherein said pattern detector and said load classifier are implemented by a micro controller (30).

6. A system for providing a load information in a DC distribution system, said system (200) comprising:
- a voltage sensor (20) for monitoring an DC output voltage to be distributed to a plurality of loads (L1 to L4); and
- at least one load monitoring apparatus (30) acccording to claim 1.

7. The system according to claim 6, wherein said system (200) is configured to detect a type of load of said plurality of loads (L1 to L4).

8. The system according to claim 6, wherein said system (200) is configured to adapted to be attached with a particular one of said plurality of loads (L1 to L4) and to control said particular one of said plurality of loads (L1 to L4) based on said provided load information.

9. A method of providing a load information in a DC distribution system, said method comprising:
- monitoring (S101) an output voltage of a DC voltage source (10);
- evaluating (S102) time-dependent changes of said monitored output voltage;
- detecting (S103) a predetermined change pattern based on said evaluation; and
- deciding (S104) about a type of load connected to said DC distribution system based on said detected predetermined change pattern.

10. A computer program product comprising code means for producing the steps of method claim 9 when run on a computing device.
